# EUROPÄISCHE PATENTANMELDUNG

(11) **EP 1 638 155 A1**
(43) Veröffentlichungstag der Anmeldung: **22.03.2006**
(21) Anmeldenummer: 04090368.4
(22) Anmeldetag: 21.09.2004
(51) Int. Cl.: H01L 51/30

(54) **Verbesserung der Leitfähigkeit einer Polymerelektrode durch Aufbringen einer darunterliegenden Metallschicht**

(71) Anmelder: Samsung SDI Germany GmbH, 12459 Berlin (DE); Samsung SDI Co., Ltd., Suwon-si, Gyeonggi-do (KR)
(72) Erfinder: Uhlig, Albrecht, 12524 Berlin (DE); Nolte, Kerstin, 10781 Berlin (DE)
(74) Vertreter: Hengelhaupt, Jürgen

(57) **Zusammenfassung**

Die Erfindung betrifft ein Substrat mit Elektrode für Anzeigeelemente und/oder Beleuchtungselemente, insbesondere für Anzeigeelemente/Beleuchtungselemente auf Basis organischer, lichtemittierender Materialien sowie ein Verfahren zu dessen Herstellung.

Das Substrat mit Elektrode soll kostengünstig herstellbar sein und eine hohe elektrische Leitfähigkeit aufweisen. Insbesondere soll die Verwendung von Standard PEDOT-Lösungen ermöglicht werden.

Dazu weist das erfindungsgemäße Substrat mit Elektrode ein Grundsubstrat (1) mit einer Schichtstruktur (2) aus Metall auf, wobei auf der Schichtstruktur (2) aus Metall eine Schichtstruktur (4) aus einem leitfähigen Polymer angeordnet ist.

## Beschreibung

Die Erfindung betrifft ein Substrat für Anzeigeelemente und/oder Beleuchtungselemente, insbesondere für Anzeigeelemente/Beleuchtungselemente auf Basis organischer, lichtemittierender Materialien sowie ein Verfahren zu dessen Herstellung mit den im Oberbegriff der Ansprüche 1 und 11 genannten Merkmalen.

Transparente Substrate finden regelmäßig als Elektrode z. B. in OLED-Displays oder in Beleuchtungselementen Verwendung. Für OLED-Displays wird als Anode häufig eine auf einem Grundsubstrat angeordnete Schicht aus Indium-Zinnoxid (ITO) verwendet.

Ein OLED Bauelement muss für einen effizienten Betrieb verschiedene Eigenschaften, wie z. B. Elektronen-, Lochleitung und Lichtemission, aufweisen. Die meisten der verwendeten Materialien erfüllen nur eine der vorgenannten Eigenschaften (Elektronen-, Lochleitung, Lichtemission) in befriedigendem Maße. Zur Verbesserung der Effizienz ist es daher bekannt, Vielschichtbauelemente zu verwenden, in denen unterschiedliche Schichten kombiniert werden. So besitzt beispielsweise eine Schicht eine herausragende Funktion bzgl. der Lochleitung, während eine andere Schicht die Funktion der Elektronenleitung besser erfüllt. Diese unterschiedlichen Schichten werden im OLED Bauelement in einer bestimmten, der Energieeffizienz des Bauelementes zuträglichen Weise angeordnet.

Im Fall der OLED-Anwendungen kann die Effizienz einer Anode, beispielsweise bestehend aus Grundsubstrat/ITO-Schicht durch die Verwendung einer zusätzlichen (auf dem ITO aufgebrachten) Lochinjektionsschicht (hole injection layer, HIL) erhöht werden. Im Allgemeinen wird Polyethylenedioxythiophene-Polystyrenesulfonate (PEDT/PSS) als HIL verwendet. Nachteilhafterweise wird die Oberfläche der ITO-Schicht aufgrund des sauren Charakters von PEDT/PSS angeätzt, so dass eine Ionendiffusion und - migration in die organischen Schichten der OLED nicht vollständig vermieden werden kann. Diese Ionen haben einen negativen Einfluss auf die Lebensdauer von OLED-Bauelementen (Nucl. Inst. And Meth. In Physics Res. B194 (2002) 346; Appl. Phys. Lett. 75 (1999) 1404; Appl. Phys. Lett. 81/6 (2002) 1119: Mat. Sci. Engin. B97 (2003) 1-4; J. Appl. Phys. 79 (1996) 2745).

Um eine Steigerung der Lebensdauer eines OLED-Bauelementes bei gleicher Effizienz erzielen zu können, ist es wünschenswert, ein Substrat mit einem gegen PEDT/PSS beständigeren Elektrodenmaterial anstelle von ITO verwenden zu können, wobei das Elektrodenmaterial kostengünstig und lichtdurchlässig sein und weiterhin eine hohe elektrische Leitfähigkeit aufweisen soll. Darüber hinaus ist es wünschenswert, dass das als Elektrode verwendete Material flexibel ist, um Anwendungen in flexiblen Bauelementen wie organischen Anzeigeelementen oder organischen Solarzellen zu ermöglichen.

Es ist bekannt, als Ersatz von ITO hochleitfähiges Polyethylenedioxythiophene (PEDT) zu verwenden. Nachteilhafterweise ist die Leitfähigkeit von PEDT begrenzt. Selbst hochleitfähiges PEDT, beispielsweise PEDT der Firma Bayer ("in situ" PEDT mit einer Leitfähigkeit von 500 S/cm) weist einen zu großen Spannungsverlust bei großflächigen OLED-Bauelementen auf, wenn es als ITO-Ersatz verwendet wird (ITO besitzt eine Leitfähigkeit von 10⁴ S/cm). Die Helligkeit der entsprechenden OLED-Bauelemente nimmt mit steigendem Abstand von den Spannungskontakten ab.

W02003106571 A1 (Siemens) beschreibt die Erhöhung der PEDT/PSS Leitfähigkeit durch den Austausch des Lösungsmittels. Im Allgemeinen ist PEDT/PSS in Wasser gelöst und weist Leitfähigkeiten bis zu 10⁻³ S/cm (H.C. Starck Baytron P TP AI 4083) auf. Mittels löslicher polymerer Formulierungen können für PEDT bis zu 130 S/cm (H.C. Starck Baytron F CPP 105D M) oder 120 S/cm (Agfa Orgacon Folie) oder 500 S/cm (H.C. Starck Polyester Folie JOF 6073 beschichtet mit "in situ" PEDT) erreicht werden. Durch den Austausch von Wasser durch Alkohole wie z.B. Ethylenglycol kann die Leitfähigkeit von PEDT/PSS um 2 Größenordnungen erhöht werden. Damit können gemäß WO2003106571 A1 Leitfähigkeiten für PEDT/PSS-Lösungen von bis zu 10⁻¹ S/cm erreicht werden. Nachteil dieser Erfindung ist daher die nicht ausreichende Leitfähigkeitserhöhung in Hinsicht auf die Ersetzung von ITO als Anodenmaterial für organische Bauelemente. Ein weiterer Nachteil dieser Erfindung ist die geringe Stabilität derartiger PEDT/PSS/Alkohol-Lösungen. Agglomeration und Gelieren treten nach einiger Zeit auf, so dass Druckbarkeit oder homogenes Prozessieren durch Spincoating zum Problem werden. Die Haltbarkeit der Lösung wird stark reduziert.

Es ist daher Aufgabe der vorliegenden Erfindung, ein Substrat für Anzeigeelemente und/oder Beleuchtungselemente, insbesondere für Anzeigeelemente/Beleuchtungselemente auf Basis organischer lichtemittierender Materialien anzugeben, welches eine hohe Lebensdauer für auf dem Substrat verwendete organische Substanzen ermöglicht, wobei das Substrat kostengünstig herstellbar sein und eine hohe elektrische Leitfähigkeit aufweisen soll. Insbesondere soll die Verwendung von Standard-PEDT -Lösungen ermöglicht werden, was im Gegensatz zu WO 03/106571 A1 deutlich höhere Leitfähigkeiten ermöglicht.

Diese Aufgaben werden erfindungsgemäß gelöst durch die Merkmale im kennzeichnenden Teil des Anspruchs 1 (Sachanspruch), des Anspruchs 11 (Verfahrensanspruch) sowie des Anspruchs 16 (Verwendungsanspruch) im Zusammenwirken mit den Merkmalen im Oberbegriff. Zweckmäßige Ausgestaltungen der Erfindung sind in den Unteransprüchen enthalten.

Ein besonderer Vorteil des erfindungsgemäßen Substrates besteht darin, dass dieses Substrat eine hohe Lebensdauer für auf dem Substrat verwendete organische Substanzen gewährleistet und gleichzeitig eine hohe elektrische Leitfähigkeit aufweist. Dazu weist das erfindungsgemäße Substrat ein Grundsubstrat mit einer Schichtstruktur aus Metall auf, wobei auf der Schichtstruktur aus Metall eine Schichtstruktur aus einem leitfähigen Polymer angeordnet ist. Vorzugsweise ist die Schichtstruktur aus Metall linienförmig ausgebildet. In einer besonders bevorzugten Ausführungsvariante der Erfindung weist die Schichtstruktur aus Metall Metalllinien mit einer Breite zwischen 50 µm und 150 µm, einer Höhe zwischen 10 nm und 200 nm auf, wobei der Abstand zwischen benachbarten Metalllinien zwischen 100 µm und 1500 µm beträgt.

Das Metall ist vorzugsweise Silber und das leitfähige Polymer ist vorzugsweise Polyethylenedioxythiophene (PEDT). Weitere bevorzugte Materialien für das Metall sind Kupfer oder Gold. Ein weiteres bevorzugtes Material für das leitfähige Polymer ist Polyanilin. Hauptidee der Erfindung ist die Erhöhung der Leitfähigkeit leitfähiger Polymere wie PEDT durch Aufbringen dünner Metallstrukturen, vorzugsweise durch Drucken dünner Metalltintenlinien auf ein Grundsubstrat (vorzugsweise Glas- oder Plastiksubstrat), welches anschließend mit dem leitfähigen Polymer, vorzugsweise PEDT beschichtet wird. Die Beschichtungstechnik kann Spincoating oder Drucken oder jede andere Beschichtungstechnik sein. Hierdurch kann die Leitfähigkeit von Polymeren wie PEDT, je nach Art der benutzten Metalltinte und Anzahl der Metalllinien, um das 20-30fache erhöht werden.

Die Schichtstruktur aus einem leitfähigen Polymer ist vorzugsweise durch eine kontinuierliche Schicht mit einer Schichtdicke zwischen 30 nm und 300 nm oder linienförmig ausgebildet. In einer besonders bevorzugten Ausführungsvariante der Erfindung weist die Schichtstruktur aus einem leitfähigen Polymer Polymerlinien mit einer Breite zwischen 100 µm und 400 µm, einer Höhe zwischen 10 nm und 200 nm auf und der Abstand zwischen benachbarten Polymerlinien beträgt zwischen 100 *µ*m und 1500 *µ*m. Vorzugsweise überdecken die Polymerlinien (Schichtstruktur aus einem leitfähigen Polymer) die Metalllinien (Schichtstruktur aus Metall) vollständig. Alternativ ist es jedoch auch möglich, dass die Polymerlinien die Metalllinien teilweise überdecken.
Der Vorteil gegenüber der in WO2003106571 A1 beschriebenen Lösung zur Erhöhung der Leitfähigkeit von PEDT/PSS besteht darin, dass in der vorliegenden Erfindung Standard-PEDT/PSS-Lösungen verwendet werden können, welche deutlich längere Standzeiten der Lösungen gewährleisten als alkoholische Lösungen.
Ein weiterer Vorteil der Erfindung gegenüber W02003106571 A1 besteht darin, dass in der vorliegenden Erfindung von PEDT als hochleitfähigem Polymer mit Leitfähigkeiten bis zu 500 S/cm ausgegangen wird, während W02003106571 A1 die Erhöhung der Leitfähigkeit von PEDT/PSS-Lösungen vorsieht, welche lediglich Leitfähigkeiten von 10⁻³ S/cm aufweisen. Eine Erhöhung der Leitfähigkeit von Standard-PEDT/PSS-Lösungen um zwei Größenordnungen, wie dies in WO2003106571 A1 angegeben wird, ist nicht ausreichend, um ITO als Anodenmaterial zu ersetzen. Durch die Erhöhung der Leitfähigkeit gemäß der vorliegenden Erfindung kann auf ITO als Anodenmaterial verzichtet werden. Dadurch sind große, flexible Bauelemente ohne sichtbaren Spannungsabfall entlang des Bauelementes und höhere Lebensdauern der Bauelemente aufgrund unterbundener Ionendiffusion und -migration realisierbar.

Das erfindungsgemäße Verfahren zur Herstellung eines Substrates für ein Anzeigeelement und/oder ein Beleuchtungselement ist durch:
- Aufbringen einer Schichtstruktur aus Metall auf ein Grundsubstrat und
- Aufbringen einer Schichtstruktur aus einem leitfähigen Polymer
   gekennzeichnet. Vorzugsweise wird das Metall linienförmig und direkt auf das Grundsubstrat aufgebracht. In einer bevorzugten Ausführungsvariante der Erfindung ist es vorgesehen, dass die Metalllinien durch Tintenstrahldrucken einer metallhaltigen Tinte aufgebracht werden.

Das leitfähige Polymer wird vorzugsweise durch Spin Coating oder Drucken aufgebracht. Als Metall wird vorzugsweise Silber und als Polymer wird vorzugsweise Polyethylenedioxythiophene verwendet. Das leitfähige Polymer wird vorzugsweise direkt auf die Schichtstruktur aus Metall (und dort, wo kein Metall vorhanden ist, direkt auf das Grundsubstrat) aufgebracht.

Erfindungsgemäß wird das oben beschriebene Substrat als Elektrode, vorzugsweise als Anode für Anzeigeelemente und/oder ein Beleuchtungselemente auf Basis organischer, lichtemittierender Materialien verwendet.

Die Erfindung wird nachstehend anhand von Ausführungsbeispielen näher erläutert.
Es zeigen:
- Fig. 1:: ein erfindungsgemäßes Substrat mit Grundsubstrat, einer linienförmigen Metallstruktur und einer kontinuierlichen Polymerschicht in schematischer, geschnittener Darstellung und
- Fig. 2:: ein erfindungsgemäßes Substrat mit Grundsubstrat, einer linienförmigen Metallstruktur und einer linienförmigen Polymerstruktur in schematischer, geschnittener Darstellung.

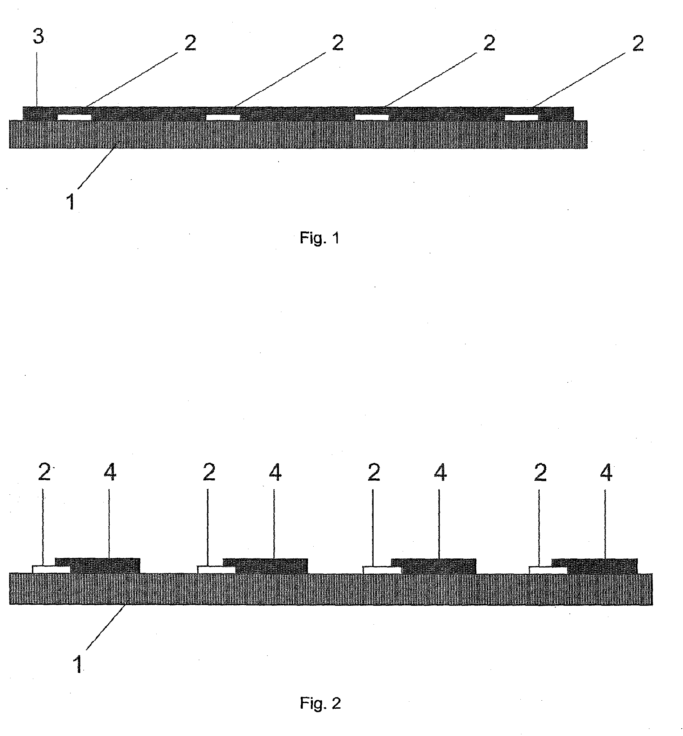

Fig. 1 zeigt ein erfindungsgemäßes Substrat mit Grundsubstrat 1, einer linienförmigen Metallstruktur 2 und einer kontinuierlichen Polymerstruktur 3 in schematischer, geschnittener Darstellung.

Als Grundsubstrat 1 wird ein Borsilikatglas verwendet. Das Grundsubstrat 1 wird durch ein 5-minütiges Ultraschallbad in Isopropanol mit anschließendem Trocknen im Stickstoffluß sowie einer 10-minütigen Behandlung mit UV/Ozon gereinigt.

In einem nächsten Schritt wird eine Silbertinte (Harima NPS-J LOT C 040218) in Linien 2 von 100 µm Breite auf das Grundsubstrat 1 mittels Inkjet-Printing gedruckt und 30 min bei 200°C im Ofen getempert.

In einem nächsten Schritt wird hochleitfähiges PEDT (Baytron® F CPP 105D M der Firma Bayer AG) als geschlossene 80 nm dicke Schicht 3 durch Spin Coating aufgetragen und anschließend für 10 Minuten bei 180°C auf einer Heizplatte getrocknet, wodurch das erfindungsgemäße, in Fig. 1 dargestellte Substrat erhalten wird. Dieses Substrat kann nun dem weiteren OLED-Herstellungsprozess (z.B. Aufbringen eines organischen, lichtemittierenden Materials, Aufbringen einer Kathode und Verkapselung) zugeführt werden.

Alternativ zu einer kontinuierlichen (geschlossenen) Polymerschicht 3 nach Fig. 1 ist es möglich, die Polymerstruktur ebenfalls linienförmig auszubilden. Dabei sollen die Polymerlinen 4 (siehe Fig. 2) die Metalllinien 2 zumindest teilweise überdecken. Hierfür werden auf das mit Metalllinien 2 versehene Grundsubstrat 1 Polymerlinien 4 durch Drucken aufgebracht und anschließend für 10 Minuten bei 180°C auf einer Heizplatte getrocknet, wodurch das erfindungsgemäße, in Fig. 2 dargestellte Substrat erhalten wird.

### Bezugszeichenliste

- 1: Grundsubstrat
- 2: Metall/Metalllinie
- 3: leitfähiges Polymer/ kontinuierliche Polymerschicht
- 4: leitfähiges Polymer/ Polymerlinie

## Patentansprüche

1. Substrat für ein Anzeigeelement und/oder ein Beleuchtungselement mit einem Grundsubstrat (1), einer auf dem Grundsubstrat angeordneten Schichtstruktur aus Metall (2) und einer darauf angeordneten Schichtstruktur aus einem leitfähigen Polymer (3, 4) .

2. Substrat nach Anspruch 1,
**dadurch gekennzeichnet, dass**
das Metall (2) Silber, Kupfer oder Gold ist.

3. Substrat nach einem der vorhergehenden Ansprüche,
**dadurch gekennzeichnet, dass**
Schichtstruktur aus Metall (2) linienförmig ausgebildet ist.

4. Substrat nach Anspruch 3,
**dadurch gekennzeichnet, dass**
die Metalllinien (2) eine Breite zwischen 50 µm und 150 µm, eine Höhe zwischen 10 nm und 200 nm aufweisen und der Abstand zwischen benachbarten Metalllinien (2) zwischen 100 µm und 1500 µm beträgt.

5. Substrat nach einem der vorhergehenden Ansprüche,
**dadurch gekennzeichnet, dass**
das leitfähige Polymer (3, 4) Polyethylenedioxythiophene oder Polyanilin ist.

6. Substrat nach einem der vorhergehenden Ansprüche,
**dadurch gekennzeichnet, dass**
die Schichtstruktur aus einem leitfähigen Polymer (3, 4) durch eine kontinuierliche Schicht mit einer Schichtdicke zwischen 30 nm und 300 nm ausgebildet ist.

7. Substrat nach mindestens einem der Ansprüche 1 bis 5,
**dadurch gekennzeichnet, dass**
die Schichtstruktur aus einem leitfähigen Polymer (3, 4) linienförmig ausgebildet ist.

8. Substrat nach Anspruch 7,
**dadurch gekennzeichnet, dass**
die Polymerlinien (4) eine Breite zwischen 100 *µ*m und 400 *µ*m, eine Höhe zwischen 10 nm und 200 nm aufweisen und der Abstand zwischen benachbarten Polymerlinien (4) zwischen 100 µm und 1500 µm beträgt.

9. Substrat nach mindestens einem der Ansprüche 9 oder 10,
**dadurch gekennzeichnet, dass**
die Polymerlinien (4) die Metalllinien (2) teilweise überdecken.

10. Substrat nach mindestens einem der Ansprüche 7 oder 8,
**dadurch gekennzeichnet, dass**
die Polymerlinien (4) die Metalllinien (2) vollständig überdecken.

11. Verfahren zur Herstellung eines Substrates für ein Anzeigeelement und/oder ein Beleuchtungselement **gekennzeichnet durch** folgende Verfahrensschritte:
- Aufbringen einer Schichtstruktur aus Metall (2) auf ein Grundsubstrat (1)
- Aufbringen einer Schichtstruktur aus einem leitfähigen Polymer (3, 4).

12. Verfahren nach Anspruch 11,
**dadurch gekennzeichnet, dass**
das Metall (2) linienförmig aufgebracht wird.

13. Verfahren nach Anspruch 12,
**dadurch gekennzeichnet, dass**
die Metalllinien (2) durch Tintenstrahldrucken einer metallhaltigen Tinte aufgebracht werden.

14. Verfahren nach Anspruch 12,
**dadurch gekennzeichnet, dass**
das leitfähigen Polymer (3, 4) durch Spin Coating oder Drucken aufgebracht wird.

15. Verfahren nach einem der Ansprüche 11 bis 14,
**dadurch gekennzeichnet, dass**
als Metall (2) Silber, Kupfer oder Gold und als Polymer (3, 4) Polyethylenedioxythiophene oder Polyanilin verwendet wird.

16. Verwendung eines Substrates nach einem der Ansprüche 1 bis 10 als Elektrode für ein Anzeigeelement und/oder ein Beleuchtungselement auf Basis organischer, lichtemittierender Materialien.

## Geänderte Patentansprüche

### Geänderte Patentansprüche gemäss Regel 86(2) EPÜ.

**1.** Substrat für ein Anzeigeelement und/oder ein Beleuchtungselement mit einem Grundsubstrat (1), einer direkt auf dem Grundsubstrat angeordneten Schichtstruktur aus Metall (2) und einer darauf angeordneten Schichtstruktur aus einem leitfähigen Polymer (3, 4).

**2.** Substrat nach Anspruch 1,
**dadurch gekennzeichnet, dass**
das Metall (2) Silber, Kupfer oder Gold ist.

**3.** Substrat nach einem der vorhergehenden Ansprüche,
**dadurch gekennzeichnet, dass**
Schichtstruktur aus Metall (2) linienförmig ausgebildet ist.

**4.** Substrat nach Anspruch 3,
**dadurch gekennzeichnet, dass**
die Metalllinien (2) eine Breite zwischen 50 µm und 150 µm, eine Höhe zwischen 10 nm und 200 nm aufweisen und der Abstand zwischen benachbarten Metalllinien (2) zwischen 100 µm und 1500 µm beträgt.

**5.** Substrat nach einem der vorhergehenden Ansprüche,
**dadurch gekennzeichnet, dass**
das leitfähige Polymer (3, 4) Polyethylenedioxythiophene oder Polyanilin ist.
